Europäisches Patentamt

European Patent Office

Office européen des brevets

(11) Veröffentlichungsnummer: **0 349 910**
**A2**

(12) **EUROPÄISCHE PATENTANMELDUNG**

(21) Anmeldenummer: 89111892.9

(22) Anmeldetag: 30.06.89

(51) Int. Cl.4: **H01L 39/24 , C04B 35/50**

(30) Priorität: **03.07.88 DE 3822502**

(43) Veröffentlichungstag der Anmeldung:
**10.01.90 Patentblatt 90/02**

(84) Benannte Vertragsstaaten:
**CH FR GB IT LI NL**

(71) Anmelder: **Kernforschungsanlage Jülich GmbH**
**Wilhelm-Johnen-Strasse**
**D-5170 Jülich(DE)**

(72) Erfinder: **Fröhlingsorf, Joachim, Dr.**
**Ropenstall 72a**
**D-5090 Leverkusen 3(DE)**
Erfinder: **Zander, Willi**
**Gutenbergstrasse 7**
**D-5170 Jülich(DE)**
Erfinder: **Poppe, Ulrich, Dr.**
**Paulistrasse 7**
**D-5000 Köln 41(DE)**
Erfinder: **Stritzker, Bernd, Prof. Dr.**
**Auf der Lache 8**
**D-5172 Linnich(DE)**

(54) **Verfahren zur Herstellung dünner Schichten aus oxidischem Hochtemperatur-Supraleiter.**

(57) Die Erfindung bezieht sich auf ein Verfahren zur Herstellung dünner Schichten aus Material eines oxidischen Hochtemperatur-Supraleiters. Das Material wird dabei als Target-Material in stöchiometrischer Zusammensetzung des Supraleiters eingesetzt. Die Schichten werden durch Abtragen von Target-Material mit Hilfe eines Lasers und Bilden eines Niederschlages auf einem erhitzten Substrat gebildet. Ziel der Erfindung ist es, ein einfaches Herstellungsverfahren zu schaffen, das ohne die Verfahrensschritte der Nachbehandlung der Schichten auskommt. Dies wird dadurch erreicht, daß die Schichten unter Sauerstoff-Partialdruck von wenigstens 0.1 mbar bei einer Temperatur der Substratoberfläche im Bereich zwischen 600°C und 900°C gebildet wird. Die Temperatur der Substratoberfläche wird zweckmäßigerweise auf einen Wert eingestellt, bei dem die Bildung von Schichten mit supraleitenden Eigenschaften optimal ist.

FIG. 1

## Verfahren zur Herstellung dünner Schichten aus oxidischem Hochtemperatur-Supraleiter

Die Erfindung bezieht sich auf ein Verfahren zur Herstellung dünner Schichten aus Material eines oxidischen Hochtemperatur-Supraleiters, bei dem das Material als Targetmaterial in stöchiometrischer Zusammensetzung des Supraleiters eingesetzt und die Schicht durch Abtragen von Targetmaterial mit Hilfe eines Lasers und Bilden eines Niederschlags auf einem erhitzten Substrat gebildet wird.

Ein derartiges Verfahren ist aus Appl. Phys. Lett. 51 (8), August 1987, S. 619 - 621, bekannt. Bei diesem bekannten Verfahren, das mit einem gepulsten Excimerlaser, 30 ns, 1 J durchgeführt wurde, wird das Substrat bei einem Druck von 1 bis $2 \times 10^{-6}$ Torr auf bis zu $450\,^{\circ}C$ erhitzt. Als Targetmaterial dient supraleitendes Material. Dabei entstehen zunächst Schichten ohne supraleitende Eigenschaften. Zur Erzielung der gewünschten supraleitenden Eigenschaften der gebildeten Schichten bzw. Filme ist eine Nachtemperung in Sauerstoffatmosphäre bei Temperaturen im Bereich von $800\,^{\circ}C$ bis $900\,^{\circ}C$ erforderlich. Dieser nachträgliche Verfahrensschritt erfordert nicht nur zusätzlichen technischen Aufwand, er steht vielmehr auch wegen der bei diesen hohen Substrattemperaturen ablaufenden unerwünschten chemischen Reaktionen zwischen Substrat und Schicht einer breiteren technischen Anwendung des Verfahrens hindernd entgegen. Hinzu kommt, daß die hocherhitzten Schichten anschließend langsam abgekühlt werden müssen. Erst nach diesem letzten Verfahrensschritt, der als wesentlich angesehen wird, nehmen die Schichten die erwünschten supraleitenden Eigenschaften an.

Es ist Aufgabe der Erfindung, ausgehend von dem eingangs bezeichneten Verfahren, ein einfacheres Verfahren zur Herstellung dünner Schichten aus oxidischem Hochtemperatur-Supraleiter zu schaffen, das ohne die Verfahrensschritte der Nachbehandlung der Schichten auskommt.

Diese Aufgabe wird gemäß der Erfindung dadurch gelöst, daß die Schichten unter Sauerstoffpartialdruck von wenigstens 0,1 mbar bei einer Temperatur der Substratoberfläche im Bereich zwischen $600\,^{\circ}C$ und $900\,^{\circ}C$ gebildet werden.

Wie sich gezeigt hat, werden durch das erfindungsgemäße Verfahren, das aus praktisch einem einzigen Verfahrensschritt besteht, unmittelbar Schichten mit supraleitenden Eigenschaften gebildet, während sich im Gegensatz hierzu bei dem oben genannten bekannten Verfahren die supraleitenden Eigenschaften erst bei der aufwendigen Nachbehandlung einstellen. Offenbar erfolgt beim Verfahren gemäß der Erfindung bereits während des Laserabtragens und der Bildung der Schichten eine Anreicherung des die Schicht bildenden Materials mit Sauerstoff. Dies führt dazu, daß sich unmittelbar Schichten mit supraleitenden Eigenschaften herstellen lassen.

Der angegebene minimale Partialdruck des Sauerstoffs (andere Gasanteile, wie beispielsweise Inertgase, sind unbedeutend) hat sich zur Bildung von Schichten mit supraleitenden Eigenschaften als erforderlich erwiesen

Der einzustellende Partialdruck des Sauerstoffs ist nach oben lediglich durch technische Nebenbedingun gen begrenzt, beispielsweise dadurch, daß es bei höherem Sauerstoffpartialdruck infolge einsetzender Kühlung nur schwer oder gar nicht möglich ist, die gewünschte Temperatur an der Substratoberfläche einzustellen.

Besonders vorteilhaft ist die Verfahrensweise gemäß Anspruch 2. Es hat sich nämlich gezeigt, daß die Bildung von Schichten mit supraleitender Eigenschaft bei einer bestimmten Temperatur im genannten Bereich - und vornehmlich einem Sauerstoffpartialdruck von 1 mbar - ein scharfes Optimum zeigt, wobei diese bestimmte, optimale Temperatur scharf einstellbar ist. Diese Optimaltemperatur, die auf der Substrat- oberfläche einzustellen ist, wurde für das Schichtmaterial mittels Thermoelementen zu $780\,^{\circ}C$ bestimmt, wobei jedoch zu berücksichtigen ist, daß die Temperaturmessung fehlerbehaftet sein kann, so daß es sich ggf. bei dem angegebenen Temperatur-Wert nicht um eine genaue Angabe handelt. Die für die Herstellung einer bestimmten Schicht zu wählende Optimaltemperatur ist jedoch in nur wenigen Versuchen leicht festzustellen und danach für die Herstellung von Schichten einstellbar.

Es empfiehlt sich, eine Temperatur der Substratoberfläche in Bereich zwischen $760\,^{\circ}C$ und $800\,^{\circ}C$ einzustellen, was - in Verbindung mit einem Sauerstoffpartial druck im Bereich um 1 mbar - in der Regel die Bildung von qualitativ guten Schichten gewährleistet.

Eine weitere, sehr vorteilhafte Verfahrensweise ist in Anspruch 4 angegeben. Diese führt dazu, da der zeitraubende Abkühlprozess nicht erforderlich ist, daß supraleitende Schichten innerhalb kurzer Zeit - Herstellung einer Schicht in weniger als 5 min herstellbar sind.

Die Anwendung einer UV-Strahlung (Excimerlaser, 248 µm) in der Nähe der Substratoberfläche wirkt sich auf die Bildung supraleitender Schichten (Erhöhung der Qualität) positiv aus, was wahrscheinlich auf die Bildung von sehr reaktivem Ozon, das sich auf dem heißen Substrat zersetzt, zurückzuführen ist.

Das Verfahren gemäß der Erfindung ist nicht nur sehr zeitsparend, sondern führt auch zu Schichten mit ausgezeichneten supraleitenden Eigenschaften und sehr glatter Oberfläche. Zudem ist auch die Bildung extrem dünner Schichten (ungefähr 30 nm Dicke) mit supraleitenden Eigenschaften erstmals möglich.

Wie sich gezeigt hat, ist das Verfahren gemäß der Erfindung für verschiedene Targetmaterialien, wie beispielsweise $YBa_2Cu_3O_7$ und $BiSrCaCuO$, anwendbar, wobei das Targetmaterial nicht, wie dies beim eingangs angegebenen bekannten Verfahren der Fall ist, aus supraleitendem Material bestehen muß. Auch lassen sich die Schichten auf verschiedenen Substratmaterialien, wie einkristallinem $SrTiO_3$, $ZrO_2$, YSZ-Keramik, aufbringen.

Im folgenden wird eine Vorrichtung zur Durchführung des Verfahrens gemäß der Erfindung näher erläutert. Sie ist in der Zeichnung schematisch dargestellt. Es werden ferner Ausführungsbeispiele zum Verfahren gemäß der Erfindung angegeben.

Es zeigen:

Figur 1 Vorrichtung zur Durchführung des Verfahrens;

Figur 2 Widerstandskennlinie einer gemäß Ausführungsbeispiel 1 hergestellten Schicht;

Figur 3 Ergebnisdiagramm einer Versuchsreihe bei 1 mbar;

Figur 4 Widerstandskennlinie einer gemäß Ausführungsbeispiel 2 hergestellten Schicht;

Figur 5 Widerstandskennlinie einer gemäß Ausführungsbeispiel 3 hergestellten Schicht.

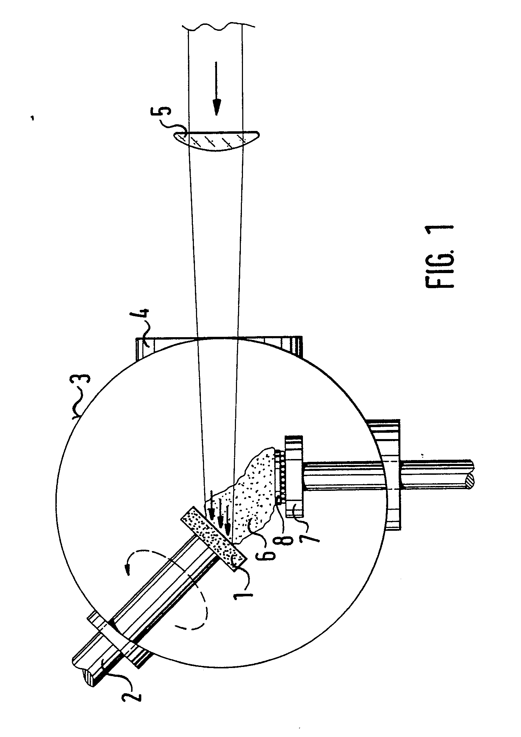

In Figur 1 ist die zur Durchführung des Verfahrens gemäß der Erfindung benutzte Apparatur wiedergegeben. Mit einem gepulsten Excimer-Laser (Lambda Phys., EMG 201) wird das Target 1, das auf einem drehbaren Halter 2 aufgeklebt ist, in einer Vakuumkammer 3 durch ein Saphirfenster 4 nach Fokussierung des Strahls mit einer Zylinderlinse 5 bestrahlt. Die hierdurch erzielte Laserabtragung führt zur Ausbildung eines Plasmas 6, das sich auf dem mit dem Heizer 7 beheizten Substrat 8 niederschlagen kann. Der Abstand zwischen Target und Substratmitte beträgt dabei etwa 3 cm.

Ausführungsbeispiele:

Die nachfolgend angegebenen Ausführungsbeispiele wurden mit einer Vorrichtung der beschriebenen Art, jedoch bei unterschiedlichen Temperaturen, mit verschiedenen Substraten und verschiedenen Targetmaterialen durchgeführt. Der eingestellte Sauerstoffpartialdruck betrug bei den Ausführungsbeispielen 1 bis 3 1 mbar und wurde dabei dynamisch eingestellt. Als Pumpe wurde eine Adsorptionspumpe verwendet, die Vakuumkammer von reinem Sauerstoff durchströmt.

Ausführungsbeispiel 1

Es wurden bei fünf unterschiedlichen Substrattemperaturen Schichten von $YBa_2Cu_3O_7$ auf $SrTiO_3$ aufgebracht und das Widerstandsverhalten zwischen Raum- und Heliumtemperatur gemessen.

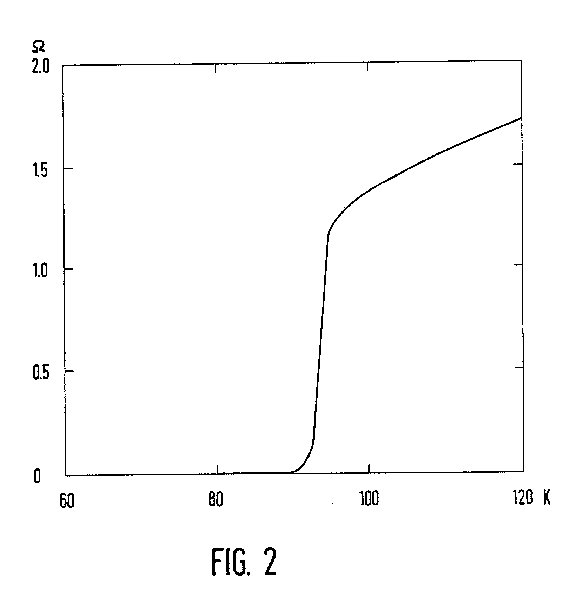

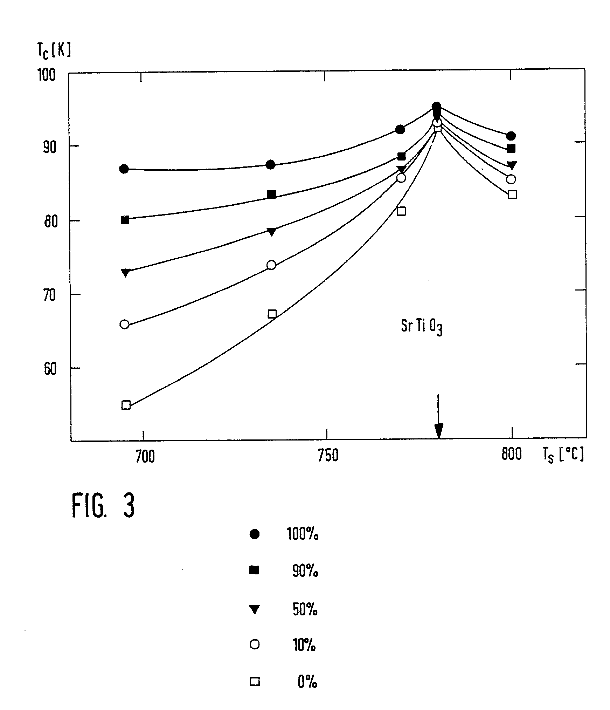

Figur 2 zeigt die Widerstandskurve einer Schicht, die bei einer Substratoberflächentemperatur ($T_S$) von 780° C (mit einem Thermoelement gemessen) hergestellt wurde. Die Kurve zeigt im Bereich um 93° K eine starke Widerstandsabnahme zur Supraleitung. In diesem Bereich wurden die Widerstandswerte bei Beginn des Abfalls (100 %) bei 90, 50, 10 % dieses Wertes sowie bei Erreichen des Wertes 0 gemessen. Diese Werte sind in Figur 3 im Vergleich zu den entsprechenden Werten der übrigen, bei anderen Substrattemperaturen hergestellten Schichten angegeben. Die Darstellung in Figur 3 zeigt, daß auch bei anderen Substrattemperaturen annähernd gleiche Einsatzpunkte (100 %) erreicht werden, die Übergänge aber deutlich breiter werden. Untersuchungen an anderen Substraten ($ZrO_2$) ergeben ein gleiches Verhalten. Wie wei tere Untersuchungen ergaben, besitzen die bei 780° C hergestellten Schichten auf einkristallinen Substraten ($SrTiO_3$, $ZrO_2$) eine Vorzugsorientierung der c-Achse senkrecht zum Substrat. Die Verringerung der Prozeßtemperatur im direkten Herstellungsprozeß erlaubt erstmalig die Herstellung extrem dünner Filme ($d \leq 30$ nm) mit dem in Fig. 2 gezeigten Widerstandsverhalten.

Die kritische Stromdichte der unter optimalen Bedingungen (780° C, 1 mbar) hergestellten Filme auf $SrTiO_3$ lag oberhalb $10^6$ A/cm$^2$ bei 77K. Die Schichten haben im Gegensatz zu den üblicherweise durch Laserabtragen hergestellten Schichten sehr glatte Oberflächen mit einer Oberflächenrauhigkeit $< 0,2$ µm und sind damit für eine Mikrostrukturierung in Kryoelektrischen Anwendungen gut geeignet.

Ausführungsbeispiel 2

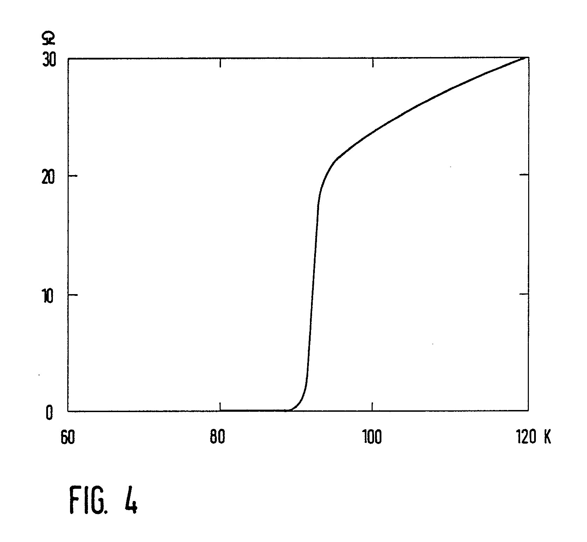

Auf anderen Substraten wurden ebenfalls dünne Schichten mit sehr guten supraleitenden Eigenschaften erhalten. Fig. 4 zeigt das Beispiel einer Probe auf YSZ-Keramik. Hier konnten ebenfalls Übergänge mit $T_C(R = 0)$ bei 92K erzielt werden. Auf YSZ wachsen die Filme jedoch polykristallin ohne Vorzugsorientierung auf. Auf einkristallinen $ZrO_2$-Substraten erhält man wiederum eine deutliche Vorzugsorientierung der c-Achse senkrecht zur Substratoberfläche, die kritische Stromdichte liegt hier oberhalb $10^5$ A/cm$^2$.

Ausführungsbeispiel 3

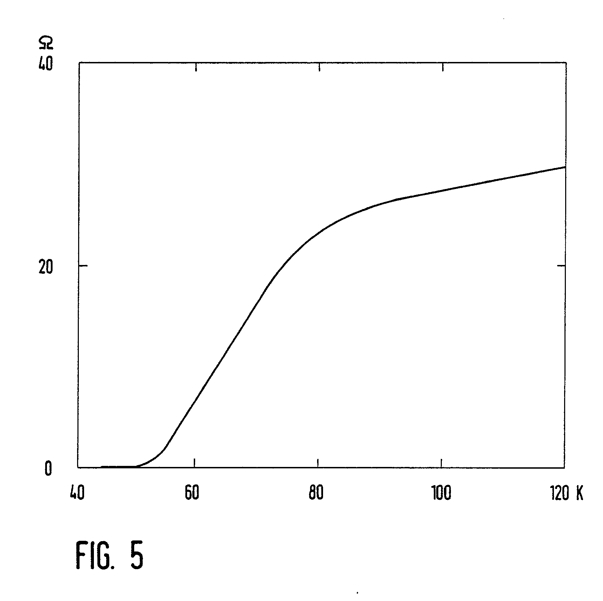

In Fig. 5 ist die Widerstandskennlinie einer BiSrCaCuO-Schicht wiedergegeben, die unter Einsatz eines nicht supraleitenden Targets hergestellt wurde. Der Sauerstoffdruck betrug 1 mbar $O_2$, die Substrattempe ratur 780° C.

Weitere Ausführungsbeispiele:

In weiteren Untersuchungen wurden Schichten aus den genannten Materialien hergestellt, wobei der Sauerstoffpartialdruck variiert wurde. Dabei zeigte sich, daß bei abnehmendem Sauerstoffpartialdruck unterhalb 1 mbar bis 0,1 mbar zwar ebenfalls Schichten mit supraleitenden Eigenschaften erhalten wurden, jedoch mit zunehmend geringerer Qualität. Bei Sauerstoffpartialdruck oberhalb 1 mbar bis 10 mbar wurden Schichten gleich guter Qualität erzielt. Da bei noch höheren Sauerstoffpartialdrucken ein Erreichen der erwünschten Substrattemperatur nicht möglich war, wurden Schichten bei höheren Sauerstoffpartialdrucken nicht hergestellt.

## Ansprüche

1. Verfahren zur Herstellung dünner Schichten aus Material eines oxidischen Hochtemperatur-Supraleiters, bei dem das Material als Targetmaterial in stöchiometrischer Zusammensetzung des Supraleiters eingesetzt und die Schicht durch Abtragen von Targetmaterial mit Hilfe eines Lasers und Bilden eines Niederschlages auf einem erhitzten Substrat gebildet wird,
**dadurch gekennzeichnet,**
daß die Schicht unter Sauerstoffpartialdruck von wenigstens 0,1 mbar bei einer Temperatur der Substratoberfläche im Bereich zwischen 600° C und 900° C gebildet wird.

2. Verfahren nach Anspruch 1,
**dadurch gekennzeichnet,**
daß die Temperatur der Substratoberfläche auf einen Wert, bei dem die Bildung von Schichten mit supraleitenden Eigenschaften optimal ist, eingestellt wird.

3. Verfahren nach Anspruch 1 oder 2,
**dadurch gekennzeichnet,**
daß die Temperatur der Substratoberfläche bei 760° C bis 800° C gehalten wird..

4. Verfahren nach einem der vorhergehenden Ansprüche,
**dadurch gekennzeichnet,**
daß die gasdichte Kammer (3), die zur Durchführung des Verfahrens eingesetzt wird, nach Bildung der Schichten ohne ein langsames Abkühlen der Schichten geflutet wird.

FIG. 1

FIG. 2

FIG. 3

FIG. 4

FIG. 5